# EUROPEAN PATENT APPLICATION

(11) **EP 0 825 640 A2**
(43) Date of publication of application: **25.02.1998**
(21) Application number: 97112783.2
(22) Date of filing: 25.07.1997
(51) Int. Cl.: H01L 21/28, H01L 29/51

(54) **FET gate insulation and process for manufacturing**

(30) Priority: 29.07.1996 US 22083 P
(71) Applicant: TEXAS INSTRUMENTS INCORPORATED, Dallas, Texas 75243 (US)
(72) Inventor: Pas, Michael F., Plano, Texas 75025 (US)
(74) Representative: Holt, Michael

(57) **Abstract**

An embodiment of the instant invention is a method of forming a transistor which includes a gate dielectric (layer 112) which is situated between a gate structure (structure 114) and a semiconductor substrate (substrate 110), the method comprising the steps of: growing [step 206] a nitrogen-containing layer (layer 118) on the substrate; depositing [step 208] a first oxygen-containing layer (layer 116) on the first nitrogen-containing layer; growing [step 210] a second oxygen-containing layer (layer 120) between the substrate and the first nitrogen-containing layer; and wherein the steps of growing the nitrogen-containing layer, depositing the first oxygen-containing layer, and growing the second oxygen-containing layer are all performed in a single processing chamber. Preferably, the nitrogen-containing layer is comprised of N₂O; the first oxygen-containing layer is comprised of DCS/N₂O; and the second oxygen-containing layer is comprised of SiO₂. The step of growing the second oxygen-containing layer is, preferably, performed after the steps of growing the nitrogen-containing layer and the depositing of the first oxygen-containing layer.

## Description

### FIELD OF THE INVENTION

The instant invention pertains to semiconductor devices and device fabrication, and more specifically to an ultra-thin stacked gate dielectric.

### BACKGROUND OF THE INVENTION

Presently, there is a great demand for shrinking semiconductor devices in addition to making these devices faster while consuming less power. One means of decreasing the size of a transistor is by decreasing the gate length of the transistor. However, this can be problematic, because the length of the channel is directly related to the gate length. Hence, as the gate length is decreased so is the channel length, and as the channel length is decreased the device is more susceptible to short circuits across the channel.

In order to use lower voltage supplies and reduce power consumption by the transistors, many attempts have been made at reducing the electrical resistance of the gate structure. One such method involves boron doping the polysilicon gate structure so that it becomes more conductive. However, boron doping of the gate structure can cause damage to the underlying channel region. More specifically, with thinner gate oxides and shorter channel lengths, any boron penetration into the channel region can cause the channel region to be short-circuited.

It is, therefore, an object of the instant invention to provide a gate insulator which will properly insulate the gate structure from the substrate without degrading the performance of the device. In addition, it is an object of the instant invention to provide a gate insulator which will inhibit the dopant used to make the gate structure more conductive from penetrating into the channel region.

### SUMMARY OF THE INVENTION

An embodiment of the instant invention is a method of forming a transistor which includes a gate dielectric which is situated between a gate structure and a semiconductor substrate, the method comprising the steps of: growing a nitrogen-containing layer on the substrate; depositing a first oxygen-containing layer on the first nitrogen-containing layer; growing a second oxygen-containing layer between the substrate and the first nitrogen-containing layer; and wherein the steps of growing the nitrogen-containing layer, depositing the first oxygen-containing layer, and growing the second oxygen-containing layer are all performed in a single processing chamber. Preferably, the nitrogen-containing layer is comprised of N₂O; the first oxygen-containing layer is comprised of DCS/ N₂O; and the second oxygen-containing layer is comprised of SiO₂. The step of growing the second oxygen-containing layer is, preferably, performed after the steps of growing the nitrogen-containing layer and the depositing of the first oxygen-containing layer.

Another embodiment of the instant invention is a method of reducing defect density of a gate dielectric which is situated between a gate structure and a semiconductor substrate, the method comprising the steps of: growing a first oxy-nitride layer on the substrate; depositing a second oxy-nitride layer on the first oxy-nitride layer; growing an oxygen-containing layer between the substrate and the first oxy-nitride layer; and wherein the gate dielectric is comprised of the first oxy-nitride layer, the second oxy-nitride layer, and the oxygen-containing layer, and the steps of growing the first oxy-nitride layer, depositing the second oxy-nitride layer, and growing the oxygen-containing layer are all performed in a single processing chamber so as to reduce the defect density of the gate dielectric. Preferably, the first oxy-nitride layer is comprised of N₂O; the second oxy-nitride layer is comprised of DCS/N₂O; and the oxygen-containing layer is comprised of SiO₂. The step of growing the oxygen-containing layer is, preferably, performed after the steps of growing the first oxy-nitride layer and the depositing of the second oxy-nitride layer.

### BRIEF DESCRIPTION OF THE DRAWINGS

The present invention will now be further described by way of example, with reference to the accompanying drawings in which:-
FIGURE 1 is a cross sectional view of a device fabricated using the method of one embodiment of the instant invention; and
FIGURE 2 is a flow chart illustrating the method of one embodiment of the instant invention.

### DETAILED DESCRIPTION OF THE DRAWINGS

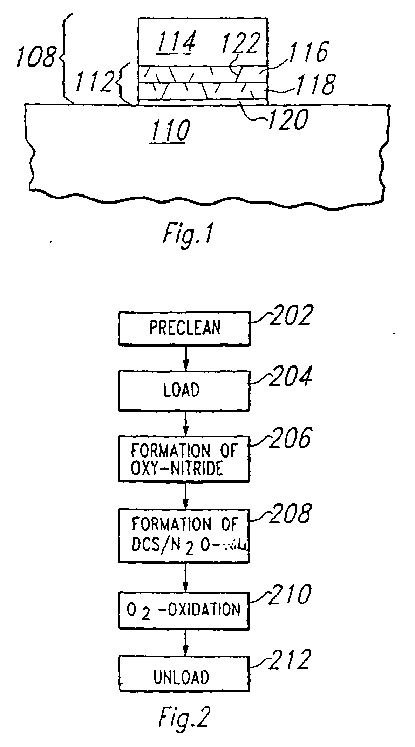

FIGURE 1 is a cross sectional view of a portion of a device which was fabricated using a method of one embodiment of the instant invention. Gate structure 108 is formed overlying semiconductor substrate 110. Gate structure 108 includes conductive gate structure 114 (which is preferably comprised of polysilicon or doped polysilicon -- preferably doped with boron) and gate insulator 112. Preferably, conductive gate structure 114 is approximately 3000 Angstroms thick, and gate insulator 112 is approximately 5 to 100 Microns thick (more preferably 5 to 45 microns thick for a transistor with a gate length of 0.18µm, 45 to 60 microns thick for a transistor with a gate length of 0.25µm, 60 to 80 microns thick for a transistor with a gate length of 0.35µm, or 80 to 100 microns thick for a transistor with a gate length of 0.5µm). In one embodiment of the instant invention, gate insulator 112 is comprised of oxide layer 120 (preferably a 5µm thick SiO₂ layer for a transistor with a 0.18µm gate length), thermally grown oxy-nitride layer 118 (preferably a 15µm thick N₂O layer for a transistor with a 0.18µm gate length), and a deposited oxide layer (preferably a DCS/N₂O deposited layer which is approximately 18µm thick for a transistor with a 0.18µm gate length). The oxide and oxy-nitride layers are important in transistor with smaller geometries because the oxy-nitride layer act as barriers so as to reduce the extent of boron penetration into the substrate during the boron doping of conductive gate structure 114. In order to provide a sufficient barrier with regards to boron penetration, it is preferable that at least one of the dielectric layers be comprised of at least 1 atomic% of nitrogen. Additionally, it is important to have at least a thin oxide layer (preferably SiO₂) between the bottom most oxy-nitride layer and the semiconductor substrate because the device performance (specifically electron mobility, and Qₛₛ) are improved with the underlying oxide layer (as opposed to a device without the oxide layer).

A problem with dielectric layers 118 and 116 is that they have micropores 122 which may cause device degradation if not accounted for. More specifically, if a micropore extends from the top surface of the dielectric layer(s) to the bottom most surface of the dielectric layer(s) and there is not underlying oxide layer, then a direct current path is established from conductive gate structure 114 to semiconductor substrate 110, thereby degrading the device. In order to account for this problem, the structure of the instant invention is comprised of two (or more) different dielectric layers and an underlying oxide layer. Different dielectric layers are utilized so that the chances of a micropore extending from the top surface of the top most dielectric layer to the bottom surface of the bottom most dielectric layer are greatly reduced.

FIGURE 2 is a flow chart illustrating the method of one embodiment of the instant invention. In step 202, semiconductor wafer 110 is cleaned. Preferably, this is accomplished by subjecting the wafer to a 0.49% HF solution or a 1% HF solution as the last step in the wafer clean process. This is followed by loading the wafer into a deposition/oxidation chamber (step 204). In step 206, oxy-nitride layer 118 is formed. Oxy-nitride layer 118 is preferably a thermally grown N₂O oxide layer. Preferably, step 206 is comprised of growing the oxy-nitride layer at between 850 and 1000°C for 10 seconds to three minutes with a pressure of approximately 5 to 750 Torr. In step 208, DCS/N₂O oxide layer 116 is deposited at between 700 and 900°C for approximately 10 seconds to 3 minutes at a pressure of between 25 and 400 Torr. Next, oxide layer 120 if thermally grown in step 210. This is preferably accomplished by subjecting the wafer to an oxygen-baring ambient which is at approximately 850 to 1000°C for approximately 10 seconds to 3 minutes at a pressure of approximately 760 Torr. Finally, the wafer is removed from the chamber and subsequent processing is performed using standard semiconductor processing techniques.

Although specific embodiments of the present invention are herein described, they are not to be construed as limiting the scope of the invention. Many embodiments of the present invention will become apparent to those skilled in the art in light of methodology of the specification.

## Claims

1. A method of forming a transistor which includes a gate dielectric which is situated between a gate structure and a semiconductor substrate, said method comprising the steps of:
growing a nitrogen-containing layer on said substrate;
depositing a first oxygen-containing layer on said nitrogen-containing layer;
growing a second oxygen-containing layer between said substrate and said first nitrogen-containing layer;
and wherein said steps of growing said nitrogen-containing layer, depositing said first oxygen-containing layer, and growing said second oxygen-containing layer are all performed in a single processing chamber.

2. The method of Claim 1, wherein said step of growing said nitrogen - containing layer comprises growing a nitrogen-containing layer comprising N₂O.

3. The method of Claim 1 or Claim 2, wherein said step of depositing said first oxygen-containing layer comprises depositing a first oxygen-containing layer comprising DCS/N₂O.

4. The method of any preceding claim, wherein said step of depositing said second oxygen-containing layer comprises depositing a second oxygen-containing layer comprising SiO₂.

5. The method of any preceding claim, further comprising performing the step of growing said second oxygen-containing layer after said steps of growing said nitrogen-containing layer and said depositing of said first oxygen-containing layer.

6. A method of reducing defect density of a gate dielectric which is situated between a gate structure and a semiconductor substrate, said method comprising the steps of:
growing a first oxy-nitride layer on said substrate;
depositing a second oxy-nitride layer on said first oxy-nitride layer;
growing an oxygen-containing layer between said substrate and said first oxy-nitride layer;
and wherein said gate dielectric is comprised of said first oxy-nitride layer, said second oxy-nitride layer, and said oxygen-containing layer, and said steps of growing said first oxy-nitride layer, depositing said second oxy-nitride layer, and growing said oxygen-containing layer are all performed in a single processing chamber so as to reduce said defect density of said gate dielectric.

7. The method of Claim 6, wherein said step of growing said first oxy-nitride layer comprises growing a first oxy-nitride layer comprising N₂O.

8. The method of Claim 6 or Claim 7, wherein said step of depositing said second oxy-nitride layer comprises a second oxy-nitride layer comprising DCS/N₂O.

9. The method of any of Claims 6 to 9, wherein said step of growing said oxygen-containing layer comprises growing an oxygen-containing layer comprising SiO₂.

10. The method of any of Claims 6 to 9, further comprising performing the step of growing said oxygen-containing layer after said steps of growing said first oxy-nitride layer and said depositing of said second oxy-nitride layer.
